# EUROPEAN PATENT APPLICATION

(11) **EP 4 756 861 A1**
(43) Date of publication of application: **10.06.2026**
(21) Application number: 25216723.4
(22) Date of filing: 18.11.2025
(51) Int. Cl.: H01J 37/145, H01J 37/09, H01J 37/26

(54) **ELECTRON MICROSCOPE AND SPECIMEN OBSERVATION METHOD**

(30) Priority: 05.12.2024 JP 2024212466
(71) Applicant: JEOL Ltd., Akishima, Tokyo 196-8558 (JP)
(72) Inventor: KURAMOTO, Tatsuru, Tokyo 196-8558 (JP); WATANABE, Jun, Tokyo 196-8558 (JP)
(74) Representative: Boult Wade Tennant LLP

(57) **Abstract**

An electron microscope (100) includes: an electron source (10) that emits an electron beam; an electrostatic/electromagnetic field superposed objective lens (20) in which an acceleration tube (240) is built into a magnetic field lens; a correction electrode (50) placed between the acceleration tube (240) and a specimen (S); and a specimen stage (30) that tiltably supports the specimen (S), wherein a positive voltage is applied to the acceleration tube (240), a negative voltage is applied to the correction electrode (50), and a potential on an optical axis (A) between the correction electrode (50) and the specimen (S) is equal to or higher than a potential of the specimen (S).

## Description

### BACKGROUND OF THE INVENTION

### Field of the Invention

The present invention relates to an electron microscope and a specimen observation method.

### Description of Related Art

Electrostatic/electromagnetic field superposed objective lenses are known as objective lenses for scanning electron microscopes. An electrostatic/electromagnetic field superposed objective lens is equipped with an acceleration tube, and an electron beam is accelerated by the acceleration tube to which high voltage is applied and decelerates just before a specimen. This enables lens aberration to be reduced and a diameter of an electron probe to be made smaller. As a result, observations can be performed at high resolution.

In the electrostatic/electromagnetic field superposed objective lens, a decelerating electric field is formed between the objective lens and the specimen. Secondary electrons emitted from the specimen are drawn into the objective lens by the decelerating electric field. Therefore, a detector that detects the secondary electrons is placed inside of the objective lens or above the objective lens.

The decelerating electric field is affected by a shape of the specimen. In particular, when the specimen is tilted, the decelerating electric field deforms. The deformation of the decelerating electric field may prevent the secondary electrons from reaching the detector, thereby causing a decline in detection efficiency. In consideration thereof, for example, in JPH10-294075 A, the decelerating electric field is corrected to reduce a decline in detection efficiency by varying a potential of the specimen according to a tilt angle of the specimen.

In this manner, in electron microscopes equipped with an electrostatic/electromagnetic field superposed objective lens, desirably, a decline in detection efficiency of secondary electrons can be reduced even when a specimen is tilted.

### SUMMARY OF THE INVENTION

According to a first aspect of the present disclosure, there is provided an electron microscope including:
an electron source that emits an electron beam;
an electrostatic/electromagnetic field superposed objective lens in which an acceleration tube is built into a magnetic field lens;
a correction electrode placed between the acceleration tube and a specimen; and
a specimen stage that tiltably supports the specimen, wherein
a positive voltage is applied to the acceleration tube,
a negative voltage is applied to the correction electrode, and
a potential on an optical axis between the correction electrode and the specimen is equal to or higher than a potential of the specimen.

According to a second aspect of the present disclosure, there is provided a specimen observation method using an electron microscope that includes:
a specimen stage that tiltably supports a specimen;
an electron source that emits an electron beam;
an electrostatic/electromagnetic field superposed objective lens in which an acceleration tube is built into a magnetic field lens; and
a correction electrode placed between the acceleration tube and the specimen,
the specimen observation method including:
   operating an optical system including the electrostatic/electromagnetic field superposed objective lens and the correction electrode;
   tilting the specimen; and
   illuminating the specimen with an electron beam to acquire an electron microscope image, wherein
   in the step of operating the optical system,
   by applying a positive voltage to the acceleration tube and applying a negative voltage to the correction electrode, an electron beam is accelerated by the acceleration tube and decelerated by a decelerating electric field formed between the acceleration tube and the specimen, and
   a potential on an optical axis between the correction electrode and the specimen is set equal to or higher than a potential of the specimen.

### BRIEF DESCRIPTION OF THE DRAWINGS

FIG. 1 illustrates an example of a configuration of an electron microscope according to the first embodiment.
FIG. 2 schematically illustrates an acceleration tube and a correction electrode.
FIG. 3 illustrates a distribution of potentials between an objective lens and a specimen.
FIG. 4 illustrates a distribution of potentials between an objective lens and a specimen in an electron microscope according to a comparative example.
FIG. 5 illustrates graphs for describing a distribution of potentials on an optical axis.
FIG. 6 is a flowchart illustrating an example of a specimen observation method.
FIG. 7 is a graph illustrating a relationship between detection efficiency of secondary electrons and voltage applied to a correction electrode.
FIG. 8 illustrates an example of a configuration of an electron microscope according to the second embodiment.

### DESCRIPTION OF THE INVENTION

According to an embodiment of the present disclosure, there is provided an electron microscope including:
an electron source that emits an electron beam;
an electrostatic/electromagnetic field superposed objective lens in which an acceleration tube is built into a magnetic field lens;
a correction electrode placed between the acceleration tube and a specimen; and
a specimen stage that tiltably supports the specimen, wherein
a positive voltage is applied to the acceleration tube,
a negative voltage is applied to the correction electrode, and
a potential on an optical axis between the correction electrode and the specimen is equal to or higher than a potential of the specimen.

In such an electron microscope, applying a negative voltage to the correction electrode can reduce the effects of deformation of the deceleration electric field caused by a tilt of the specimen. In addition, in such an electron microscope, since a potential on an optical axis between the correction electrode and the specimen is equal to or higher than a potential of the specimen, secondary electrons can be drawn into the objective lens and a decline in detection efficiency of the secondary electrons can be reduced.

According to an embodiment of the present disclosure, there is provided a specimen observation method using an electron microscope that includes:
a specimen stage that tiltably supports a specimen;
an electron source that emits an electron beam;
an electrostatic/electromagnetic field superposed objective lens in which an acceleration tube is built into a magnetic field lens; and
a correction electrode placed between the acceleration tube and the specimen,
the specimen observation method including:
   operating an optical system including the electrostatic/electromagnetic field superposed objective lens and the correction electrode;
   tilting the specimen; and
   illuminating the specimen with an electron beam to acquire an electron microscope image, wherein
   in the step of operating the optical system,
   by applying a positive voltage to the acceleration tube and applying a negative voltage to the correction electrode, an electron beam is accelerated by the acceleration tube and decelerated by a decelerating electric field formed between the acceleration tube and the specimen, and
   a potential on an optical axis between the correction electrode and the specimen is set equal to or higher than a potential of the specimen.

In such a specimen observation method, applying a negative voltage to the correction electrode can reduce the effects of deformation of the deceleration electric field caused by a tilt of the specimen. In addition, in such a specimen observation method, since a potential on an optical axis between the correction electrode and the specimen can be made equal to or higher than a potential of the specimen, secondary electrons can be drawn into the objective lens and a decline in detection efficiency of the secondary electrons can be reduced.

Now preferred embodiments of the present invention will be described in detail with reference to the drawings. The embodiments described below are not intended to unduly limit the contents of the present invention described in the claims. Further, all of the components described below are not necessarily essential requirements of the present invention.

### 1. First Embodiment

### 1.1. Electron Microscope

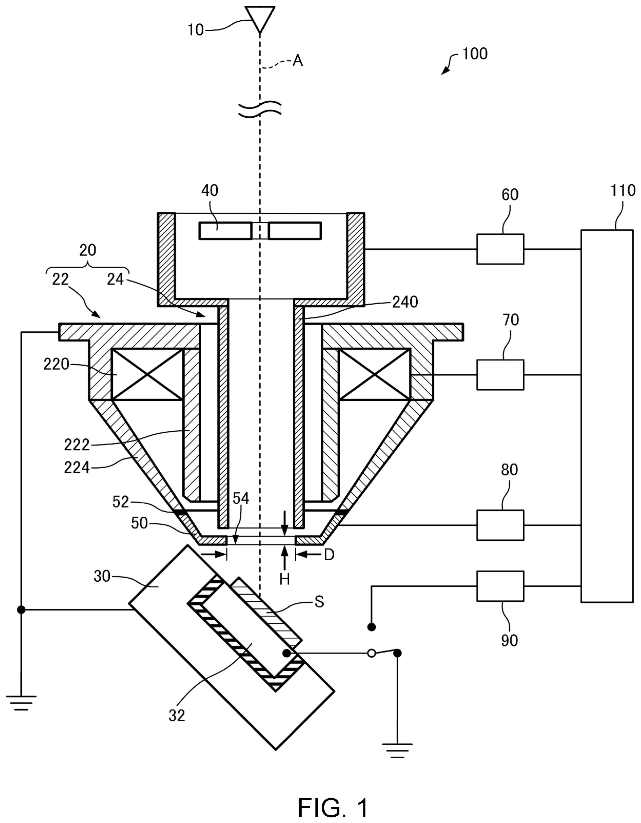

First, an electron microscope according to the first embodiment will be described with reference to the drawings. FIG. 1 illustrates an example of a configuration of an electron microscope 100 according to the first embodiment.

As illustrated in FIG. 1, the electron microscope 100 includes an electron source 10, an electrostatic/electromagnetic field superposed objective lens 20 (hereinafter, also simply referred to as an "objective lens"), a specimen stage 30, a detector 40, a correction electrode 50, an acceleration power supply 60, a coil power supply 70, a correction power supply 80, a specimen power supply 90, and a control unit 110. The electron microscope 100 is a scanning electron microscope that forms an electron probe by focusing an electron beam, scans a specimen S with the electron probe, and acquires a scanning electron microscope image (SEM image).

The electron source 10 is, for example, an electron gun that accelerates electrons emitted from a cathode toward an anode. The electron microscope 100 has an optical system including the objective lens 20 and the correction electrode 50. Although not illustrated, the optical system includes a condenser lens that concentrates the electron beam, a deflector that deflects the electron beam, and an aperture that cuts off a part of the electron beam.

The objective lens 20 is a lens for focusing the electron probe on a surface of the specimen S. The objective lens 20 includes a magnetic field lens 22 and an electrostatic lens 24. The objective lens 20 can achieve high resolution even at a low accelerating voltage by combining the magnetic field lens 22 and the electrostatic lens 24.

The magnetic field lens 22 includes a coil 220, an upper pole 222, and a lower pole 224. The coil 220 generates a magnetic field. The magnetic field generated by the coil 220 is confined within a yoke (magnetic path) formed by the upper pole 222 and the lower pole 224 and leaked onto an optical axis A through an opening (gap) between the upper pole 222 and the lower pole 224. The upper pole 222 constitutes an upper side of the yoke (magnetic path) and the lower pole 224 constitutes a lower side of the yoke (magnetic path). For example, the opening is provided along the optical axis A, with the upper pole 222 positioned above and the lower pole 224 positioned below the optical axis A. The upper pole 222 and lower pole 224 are made of a magnetic material. For example, the upper pole 222 and lower pole 224 are made of a soft magnetic material such as pure iron or permendur.

The optical axis A is a straight line that passes through a center of the optical system including the objective lens 20. The electron beam emitted from the electron source 10 advances along the optical axis A and enters the specimen S. In addition, the secondary electrons emitted from the specimen S advance along the optical axis A and are detected by the detector 40.

The coil 220 is controlled by the coil power supply 70. The coil power supply 70 controls a coil current flowing through the coil 220. The upper pole 222 and the lower pole 224 are connected to ground. Ground is the reference potential for the apparatus, such as the ground potential (0 V).

The electrostatic lens 24 includes an acceleration tube 240 and the lower pole 224. The acceleration tube 240 is built into the magnetic field lens 22. The acceleration tube 240 is placed inside of the cylindrical upper pole 222. The acceleration tube 240 has a cylindrical shape and a central axis of the acceleration tube 240 coincides with the optical axis A. A lower end of the acceleration tube 240 is positioned above the correction electrode 50.

A positive voltage is applied to the acceleration tube 240 by the acceleration power supply 60 with respect to the upper pole 222 and the lower pole 224. The electron beam can be accelerated by applying a positive voltage to the acceleration tube 240. In addition, a decelerating electric field that decelerates the electron beam is formed between the lower end of the acceleration tube 240 and the specimen S. The electron beam is decelerated by the decelerating electric field.

As described above, in the objective lens 20, the electron beam is accelerated inside of the acceleration tube 240, decelerated by the decelerating electric field, and enters the specimen S. Therefore, in the objective lens 20, since an energy level of the electron beam passing through the magnetic field lens 22 is high, chromatic aberration due to the magnetic field lens 22 can be reduced and the diameter of the electron probe can be made smaller. Furthermore, in the objective lens 20, the decelerating electric field acts as an electrostatic lens. The electrostatic lens is formed closer to the specimen S than the magnetic field lens. Therefore, in the objective lens 20, since a position of a main surface of the lens as a whole approaches the specimen S, a focal length can be shortened and the diameter of the electron probe can be made smaller.

The specimen stage 30 tiltably supports the specimen S. The specimen stage 30 has a tilting mechanism for tilting the specimen S. The specimen stage 30 may further have a moving mechanism for moving the specimen S in a horizontal direction and a moving mechanism for moving the specimen S in a height direction. The specimen stage 30 is connected to ground.

A specimen holder 32 for holding the specimen S is mounted to the specimen stage 30. The specimen holder 32 and the specimen stage 30 are electrically insulated from each other. The electron microscope 100 is provided with a switch for switching between a state where the specimen holder 32 and ground are electrically connected and a state where the specimen holder 32 and the specimen power supply 90 are electrically connected. The specimen holder 32 may be connected to ground or connected to the specimen power supply 90 that outputs 0 V.

The detector 40 detects secondary electrons emitted from the specimen S when the specimen S is illuminated with the electron beam. The secondary electrons emitted from the specimen S are drawn into the objective lens 20 by the decelerating electric field formed between the lower end of the acceleration tube 240 and the specimen S. In order to detect the secondary electrons drawn into the objective lens 20, the detector 40 is placed inside of the objective lens 20 or above the objective lens 20.

The correction electrode 50 is connected to the lower pole 224 of the objective lens 20 via an insulating portion 52. The correction electrode 50 and the objective lens 20 are electrically insulated from each other by the insulating portion 52. For example, the insulating portion 52 may be an insulating member made of an insulating material or a space. The correction electrode 50 is made of the same magnetic material as the lower pole 224 or a magnetic material with properties similar to those of the lower pole 224. Therefore, the correction electrode 50 can function as a part of the objective lens 20. For example, the correction electrode 50 may have a function to reduce leakage of the magnetic field generated by the magnetic field lens 22 and reduce leakage of the electric field generated by the acceleration tube 240.

For example, the correction electrode 50 is disk-shaped and has a through-hole 54 centered on the optical axis A. The electron beam emitted from the electron source 10 passes through the through-hole 54 and illuminates the specimen S. A negative voltage is applied to the correction electrode 50 by the correction power supply 80 with respect to the upper pole 222 and the lower pole 224. The correction electrode 50 can reduce the effects of deformation of the deceleration electric field caused by the tilt of the specimen S.

For example, a voltage of approximately from +several kV to +tens of kV is applied to the acceleration tube 240, a voltage of approximately from tens of volts to 100 V is applied to the correction electrode 50, and the upper pole 222, the lower pole 224, and the specimen S are connected to ground.

The control unit 110 controls each unit that constitutes the electron microscope 100. For example, the control unit 110 controls the acceleration power supply 60, the coil power supply 70, the correction power supply 80, and the specimen power supply 90. By controlling these power supplies, the control unit 110 controls potentials of the acceleration tube 240 (electrostatic lens 24), the magnetic field lens 22, the correction electrode 50, and the specimen S. In addition, the control unit 110 controls the specimen stage 30.

For example, the control unit 110 includes a processor such as a central processing unit (CPU) and a storage unit (memory) such as a random access memory (RAM) and a read only memory (ROM). The storage unit stores programs for performing various kinds of control as well as data. Functions of the control unit 110 can be realized by having the processor execute the programs. Note that the functions of the control unit 110 may be realized by, for example, a general-purpose circuit such as a microcontroller or a microprocessor that operates according to a program or a dedicated circuit such as an application-specific integrated circuit (ASIC).

### 1.2. Correction Electrode

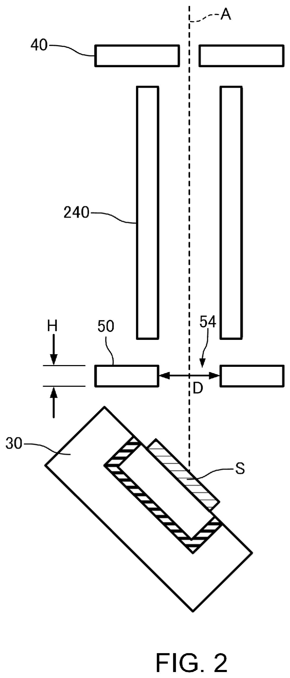

FIG. 2 schematically illustrates the acceleration tube 240 and the correction electrode 50. The correction electrode 50 is thick along the optical axis A. A height H of the correction electrode 50 is smaller than an inner diameter D of the correction electrode 50. In other words, H < D is satisfied. The height H of the correction electrode 50 is the length (thickness) of the correction electrode 50 along the optical axis A. The inner diameter D of the correction electrode 50 is a diameter of the through-hole 54. The inner diameter D of the correction electrode 50 is, for example, around several mm.

The decelerating electric field formed between the lower end of the acceleration tube 240 and the specimen S is affected by the shape of the specimen S, and in particular, the decelerating electric field deforms when the specimen S is tilted. For example, when the specimen S is tilted, the decelerating electric field becomes asymmetrical with respect to the optical axis A. The decelerating electric field imparts a deflection action on electrons moving along the optical axis A. Therefore, the deformation of the decelerating electric field causes an orbit of the electron beam to deviate from the optical axis A or, in other words, an axial deviation occurs. In addition, since an orbit of the secondary electrons emitted from the specimen S is bent by the deformation of the decelerating electric field, the secondary electrons fail to reach the detector 40, thereby causing a decline in detection efficiency.

The correction electrode 50 reduces the effects of deformation of the deceleration electric field caused by the tilt of the specimen S. The correction electrode 50 weakens the decelerating electric field so that the effects of deformation of the decelerating electric field on the electron beam and the secondary electrons decrease. Specifically, a negative voltage is applied to the correction electrode 50 to weaken the decelerating electric field to a level where the decelerating electric field no longer affects the electron beam on the optical axis A and the secondary electrons on the optical axis A. Accordingly, the effect of the deformation of the deceleration electric field on the electron beam and secondary electrons can be reduced. Therefore, with the electron microscope 100, an axial deviation of the electron beam caused by tilting the specimen S can be reduced. Furthermore, with the electron microscope 100, a decline in the detection efficiency of secondary electrons caused by tilting the specimen S can be reduced.

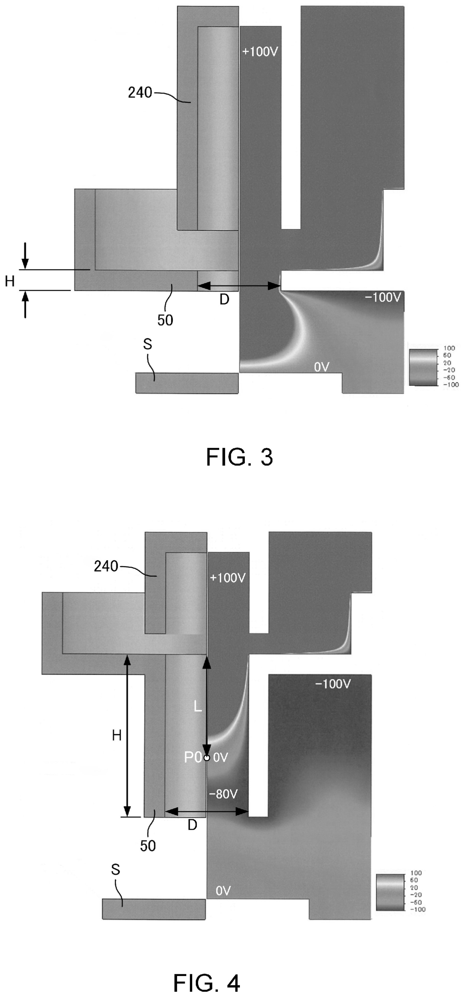

FIG. 3 illustrates a distribution of potentials between the objective lens 20 and the specimen S in the electron microscope 100. FIG. 4 illustrates a distribution of potentials between the objective lens 20 and the specimen S in an electron microscope according to a comparative example. H < D is satisfied in FIG. 3 and H > D is satisfied in the comparative example in FIG. 4. FIGS. 3 and 4 represent calculation results of the distribution of potentials in a state where +10 kV is applied to the acceleration tube 240, -100 V is applied to the correction electrode 50, and 0 V is applied to the specimen S. In FIGS. 3 and 4, a range from -100 V to +100 V is illustrated using color changes for the sake of convenience. While regions with potentials higher than +100 V exist since +10 kV is applied to the acceleration tube 240, potentials higher than +100 V are illustrated in the same color as +100 V in FIGS. 3 and 4.

As illustrated in FIG. 4, when the height H of the correction electrode 50 is greater than the inner diameter D of the correction electrode 50 or, in other words, when H > D, the effect of the electric field generated by the correction electrode 50 extends to the optical axis A. Therefore, there is a region of which the potential is lower than 0 V on the optical axis A. Since the secondary electrons cannot cross the region of which the potential is lower than 0 V, the secondary electrons emitted from the specimen S are pushed back toward the specimen S in this region. Therefore, the detection efficiency of secondary electrons by the detector 40 declines.

Conversely, when the height H of the correction electrode 50 in FIG. 3 is smaller than the inner diameter D of the correction electrode 50 (when H < D), the potential is always higher than 0 V on the optical axis A between the objective lens 20 and the specimen S. As a result, the secondary electrons emitted from the specimen S can be drawn into the acceleration tube 240. Therefore, a decline in the detection efficiency of secondary electrons by the detector 40 can be reduced.

Here, as illustrated in FIG. 4, in a direction from the electron source 10 toward the specimen S, if a position P0 is where the potential on the optical axis A changes from a positive value to a negative value (where the potential becomes 0 V), then a distance L between the upper end of the correction electrode 50 and the position P0 is greater than the inner diameter D of the correction electrode 50. As a result, by making the height H of the correction electrode 50 smaller than the inner diameter D of the correction electrode 50, the potential on the optical axis A in the objective lens 20 can be set to 0 V or higher or, in other words, equal to higher than the potential of the specimen S. Therefore, by making the height H of the correction electrode 50 smaller than the inner diameter D of the correction electrode 50, the secondary electrons emitted from the specimen S can be drawn into the acceleration tube 240.

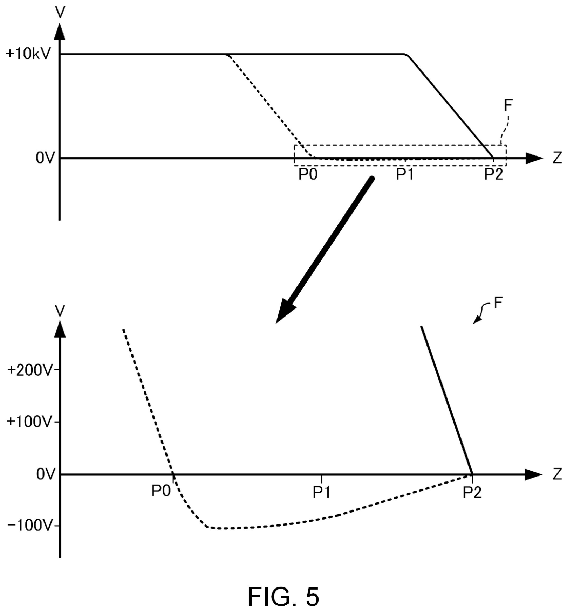

FIG. 5 illustrates a graph for describing a distribution of potentials on the optical axis A between the objective lens 20 and the specimen S. An abscissa of the graph in FIG. 5 represents a position on the optical axis A (Z-axis) and an ordinate represents potential. In addition, in FIG. 5, a case where H < D is depicted by a solid line and a case where H > D is depicted by a dashed line. Note that FIG. 5 also illustrates a graph providing an enlarged view of inside of a frame F.

A position P0 on the Z-axis corresponds to a position P0 in FIG. 4 where the potential on the optical axis A changes from a positive value to a negative value. In addition, a position P1 is a position of the lower end of the correction electrode 50. In other words, a side of a -Z direction of the position P1 is inside of the objective lens 20. A position P2 is a position on a surface of the specimen S. A section between the position P1 and the position P2 indicates the optical axis A between the correction electrode 50 and the specimen S. Note that the potential of the specimen S is 0 V in the graphs illustrated in FIG. 5.

When H > D as illustrated in FIG. 5, the potential between the position P0 and the position P2 on the optical axis A is lower than 0 V. Therefore, the secondary electrons emitted from the specimen S are pushed back toward the specimen S. Conversely, when H < D, the potential on the optical axis A does not drop below 0 V. Therefore, the secondary electrons advance in the +Z direction along the optical axis A and are drawn into the objective lens 20. Accordingly, a decline in the detection efficiency of secondary electrons by the detector 40 can be reduced.

### 1.3. Specimen Observation Method

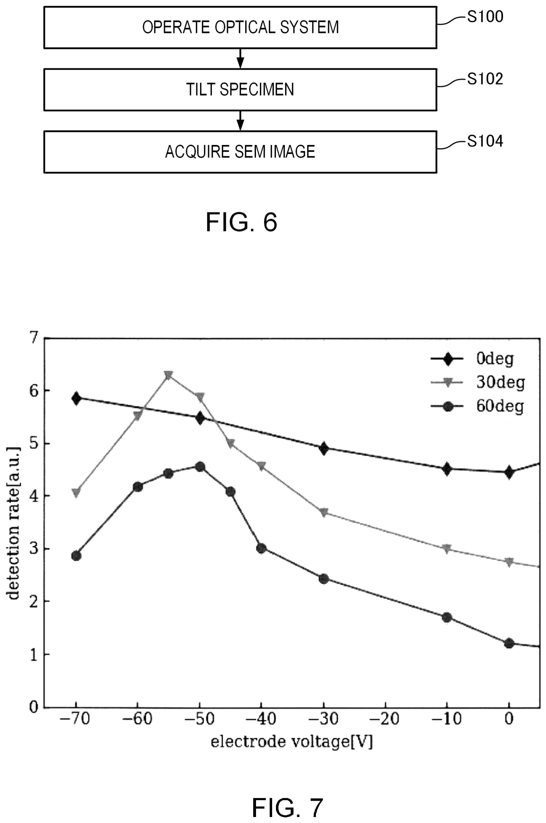

FIG. 6 is a flow chart illustrating an example of the specimen observation method using the electron microscope 100.

First, the optical system is operated (step S100).

When a user inputs conditions of the optical system via an operating unit such as a graphical user interface (GUI), the control unit 110 controls the optical system including the objective lens 20 and the correction electrode 50 based on the input conditions of the optical system. The control unit 110 controls the coil power supply 70 based on conditions of the optical system. Accordingly, a coil current according to the input conditions of the optical system flows through the coil 220. In addition, the control unit 110 controls the acceleration power supply 60 based on conditions of the optical system. Accordingly, a voltage according to the input conditions of the optical system is applied to the acceleration tube 240.

Furthermore, the control unit 110 controls the correction power supply 80 based on conditions of the optical system. A storage unit of the control unit 110 stores a database that associates the conditions of the optical system with optimum values of the voltage (hereinafter, also referred to as "correction voltage") to be applied to the correction electrode 50. As conditions of the optical system, for example, a working distance (WD) and a voltage applied to the acceleration tube 240 are registered in the database.

The control unit 110 acquires information on the working distance (WD) and the voltage applied to the acceleration tube 240 as the conditions of the optical system, refers to the database stored in the storage unit, and selects an optimal value of the correction voltage from the conditions of the working distance and the voltage applied to the acceleration tube 240. The control unit 110 controls the correction power supply 80 so that the selected optimal value of the correction voltage is applied to the correction electrode 50. Note that when the conditions of the optical system do not match optical conditions registered in the database, the control unit 110 may calculate a relational expression representing a relationship between the optical conditions and the correction voltage from data registered in the database and determine an optimal value of the correction voltage using the relational expression.

In the electron microscope 100, by applying a positive voltage to the acceleration tube 240 and applying a negative voltage to the correction electrode 50, the electron beam is accelerated by the acceleration tube 240 and decelerated by the decelerating electric field formed between the acceleration tube 240 and the specimen S. In addition, the potential on the optical axis A between the correction electrode 50 and the specimen S is set equal to or higher than the potential of the specimen S. In other words, a minimum potential on the optical axis A between the correction electrode 50 and the specimen S is set equal to or higher than the potential of the specimen S.

Next, the specimen S is tilted using the specimen stage 30 (step S102). The control unit 110 receives information on a tilt angle input by the user and controls the specimen stage 30 so that the specimen S tilts to the tilt angle. Accordingly, the specimen S can be tilted at a desired tilt angle.

Next, the specimen S is illuminated with the electron beam and an SEM image is acquired (step S104). When the user sets observation conditions such as an observation magnification via the operating unit, the set observation conditions are reflected on processing by the control unit 110. Accordingly, an SEM image at a desired observation magnification can be acquired.

In the electron microscope 100, an SEM image is acquired by focusing an electron beam and forming an electron probe, scanning the specimen S with the electron probe, and detecting the secondary electrons emitted from each illumination position with the detector 40.

In this case, since a negative voltage is applied to the correction electrode 50, the effects of deformation of the deceleration electric field caused by the tilt of the specimen S can be reduced. Furthermore, since the potential on the optical axis A between the correction electrode 50 and the specimen S is equal to or higher than the potential of the specimen S, a decline in detection efficiency of the secondary electrons can be reduced.

By following the steps described above, an SEM image can be obtained.

Note that when the specimen S is tilted by a first tilt angle in step S102, the correction voltage applied to the correction electrode 50 is to be constant even when the specimen S is tilted by a second tilt angle that differs from the first tilt angle after step S104. Therefore, the control unit 110 controls the correction power supply 80 such that the correction voltage remains constant without changing even when the tilt angle of the specimen S is changed from the first tilt angle to the second tilt angle.

FIG. 7 is a graph illustrating a relationship between the detection efficiency of secondary electrons and the correction voltage applied to the correction electrode 50. An abscissa of the graph in FIG. 7 represents correction voltage and an ordinate represents the detection efficiency of secondary electrons of 50 eV or lower. FIG. 7 illustrates calculation results when the tilt angle is 0 degree, when the tilt angle is 30 degrees, and when the tilt angle is 60 degrees, respectively.

As illustrated in FIG. 7, when the tilt angle is 60 degrees, the detection efficiency is maximized at a correction voltage of -50 V. When the correction voltage is -50 V, high detection efficiency is also achieved both at a tilt angle of 30 degrees and at a tilt angle of 0 degrees. Since the change in the value of correction voltage that maximizes detection efficiency is small even when the tilt angle changes, the correction voltage need not need be changed even when the tilt angle changes.

### 1.4. Effects

The electron microscope 100 includes: the electron source 10 that emits electron beams; the electrostatic/electromagnetic field superposed objective lens 20 in which the acceleration tube 240 is built into the magnetic field lens 22; the correction electrode 50 placed between the acceleration tube 240 and the specimen S; and the specimen stage 30 that tiltably supports the specimen S. In addition, a positive voltage is applied to the acceleration tube 240, a negative voltage is applied to the correction electrode 50, and the potential on the optical axis A between the correction electrode 50 and the specimen S is equal to or higher than the potential of the specimen S.

As described above, in the electron microscope 100, the electron beam is accelerated by applying a positive voltage to the acceleration tube 240 and the electron beam is decelerated by the decelerating electric field formed between the lower end of the acceleration tube 240 and the specimen S. Therefore, in the electron microscope 100, an aberration of the objective lens 20 can be reduced and the electron probe diameter can be made smaller. In addition, in the electron microscope 100, the correction electrode 50 can reduce the effects of deformation of the deceleration electric field caused by tilting the specimen S. Furthermore, in the electron microscope 100, since the potential on the optical axis A between the correction electrode 50 and the specimen S is equal to or higher than the potential of the specimen S, secondary electrons emitted from the specimen S can be drawn into the acceleration tube 240 and a decline in detection efficiency of the secondary electrons can be reduced.

In addition, in the electron microscope 100, the voltage applied to the correction electrode 50 need not be changed according to the tilt angle of the specimen S and the voltage applied to the correction electrode 50 can be kept constant even if the tilt angle of the specimen S changes.

For example, when reducing a decline in the detection efficiency of secondary electrons by changing the potential of the specimen according to the tilt angle of the specimen, applying a positive voltage to the specimen reduces a potential difference between the electrostatic/electromagnetic field superposed objective lens and the specimen and weakens the effect of reducing aberration. Furthermore, changing the potential of the specimen according to the tilt angle of the specimen causes energy of the electron beam reaching the specimen to change. Changes in the energy of the electron beam reaching the specimen necessitate axis alignment to align the electron beam with the optical axis A and focus adjustment. In addition, it becomes difficult to use a manipulator that comes into contact with the specimen and to measure absorption current.

Conversely, in the electron microscope 100, since the voltage applied to the correction electrode 50 need not be changed according to the tilt angle of the specimen S, the potential difference between the objective lens 20 and the specimen S can be kept constant even if the tilt angle of the specimen S is changed. Furthermore, in the electron microscope 100, since the voltage applied to the correction electrode 50 need not be changed according to the tilt angle of the specimen S, there is no need to perform axis alignment or focus readjustment even if the tilt angle of the specimen S is changed. In addition, in the electron microscope 100, since the specimen S can be kept at ground potential, a manipulator that comes into contact with the specimen S can be used and an absorption current can be measured.

As described above, in the electron microscope 100, since there is no need to perform axis alignment or focus readjustment and a manipulator and the like can be used even if the tilt angle of the specimen S is changed, throughput can be improved particularly in apparatuses equipped with an SEM column and an FIB column.

In the electron microscope 100, the length (height H) of the correction electrode 50 along the optical axis A is smaller than the inner diameter D of the correction electrode 50. For this reason, when reducing the effect of the decelerating electric field caused by the tilt of the specimen S by applying a negative voltage to the correction electrode 50, the potential on the optical axis A between the correction electrode 50 and the specimen S can be set equal to or higher than the potential of the specimen S. Therefore, in the electron microscope 100, a decline in the detection efficiency of secondary electrons caused by the tilt of the specimen S can be reduced.

In the electron microscope 100, the electrostatic/electromagnetic field superposed objective lens 20 has the coil 220 that generates a magnetic field and the upper pole 222 and the lower pole 224 for forming a magnetic field on the optical axis A. In addition, the correction electrode 50 is made of a magnetic material and connected to the lower pole 224 via the insulating portion 52. Therefore, in the electron microscope 100, the correction electrode 50 can be made to function as a part of the objective lens 20.

The electron microscope 100 includes the detector 40 that detects secondary electrons emitted from the specimen S and drawn into the electrostatic/electromagnetic field superposed objective lens 20. In the electron microscope 100, since the potential on the optical axis A between the correction electrode 50 and the specimen S is equal to or higher than the potential of the specimen S, a decline in the detection efficiency of the secondary electrons by the detector 40 can be reduced.

A specimen observation method using the electron microscope 100 includes the steps of: operating an optical system including the objective lens 20 and the correction electrode 50; tilting the specimen S; and illuminating the specimen S with an electron beam to acquire an electron microscope image. In addition, in the step of operating the optical system, by applying a positive voltage to the acceleration tube 240 and applying a negative voltage to the correction electrode 50, the electron beam is accelerated by the acceleration tube 240 and decelerated by the decelerating electric field formed between the acceleration tube 240 and the specimen S to set the potential on the optical axis A between the correction electrode 50 and the specimen S equal to or higher than the potential of the specimen S.

Therefore, with the specimen observation method using the electron microscope 100, the diameter of the electron probe can be reduced and observations can be performed with high resolution. Furthermore, a decline in the detection efficiency of secondary electrons caused by the tilt of the specimen S can be reduced.

The specimen observation method using the electron microscope 100 includes a step of changing a tilt angle of the specimen S, and the voltage applied to the correction electrode 50 is kept constant even when the tilt angle of the specimen S is changed. Therefore, in the electron microscope 100, there is no need to perform axis alignment to align the electron beam with the optical axis A and focus readjustment even when the tilt angle of the specimen S is changed.

### 1.5. Modifications

While the storage unit stores a database associating conditions of the optical system and an optimal value of correction voltage with each other in the embodiment described above, the storage unit may store a relational expression representing a relationship between conditions of the optical system and an optimal value of correction voltage. In this case, the control unit 110 substitutes the conditions of the optical system into the relational expression to calculate the optimal value of correction voltage. In addition, while the working distance and the voltage applied to the acceleration tube 240 have been described as an example of the conditions of the optical system in the embodiment described above, the conditions of the optical system are not limited thereto. As the conditions of the optical system, other conditions of the optical system that vary the value of the correction voltage such as accelerating voltage can be used. Furthermore, the conditions of the optical system for determining the correction voltage may be one condition or a plurality of conditions. For example, as the conditions of the optical system for determining the correction voltage, only the voltage applied to the acceleration tube 240 which is a parameter that most affects the correction voltage may be used.

### 2. Second Embodiment

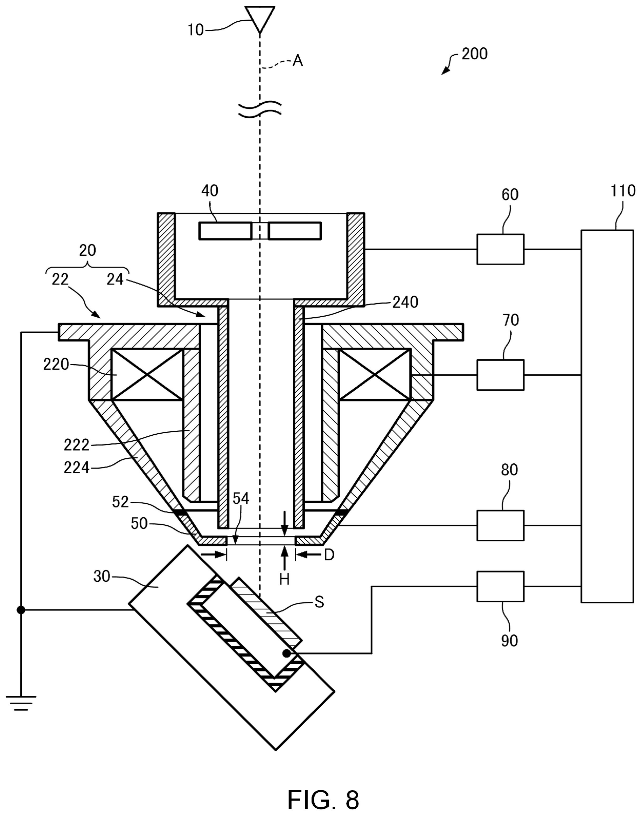

Next, an electron microscope according to a second embodiment will be described with reference to the drawings. FIG. 8 illustrates an example of a configuration of an electron microscope 200 according to the second embodiment. Hereinafter, in the electron microscope 200 according to the second embodiment, members having similar functions to the components of the electron microscope 100 according to the first embodiment will be denoted by same reference signs and a detailed description thereof will be omitted.

The electron microscope 200 includes the specimen power supply 90 that applies a negative voltage to the specimen S. In the electron microscope 200, by applying a negative voltage to the specimen S, a high-resolution SEM image can be acquired using a deceleration method that decelerates the electron beam immediately before the electron beam illuminates the specimen S.

The correction power supply 80 operates in conjunction with the specimen power supply 90. For example, when the specimen power supply 90 applies a negative voltage to the specimen S, the correction power supply 80 adds a value according to the negative voltage applied to the specimen S and applies a voltage to the correction electrode 50. Accordingly, in the electron microscope 200, the potential difference between the specimen S and the correction electrode 50 can be made equivalent to the potential difference between the specimen S and the correction electrode 50 in the electron microscope 100 described earlier. Therefore, in the electron microscope 200, the correction electrode 50 can reduce the effects of deformation of the deceleration electric field caused by tilting the specimen S and a decline in the detection efficiency of secondary electrons can be reduced in a similar manner to the electron microscope 100.

When the specimen power supply 90 is operated to apply a negative voltage to the specimen S, the control unit 110 determines the voltage applied to the correction electrode 50 based on the voltage applied to the specimen S. The control unit 110 controls the correction power supply 80 so that the determined voltage is applied to the correction electrode 50. Accordingly, in the electron microscope 200, the potential on the optical axis A between the correction electrode 50 and the specimen S can be set equal to or higher than the potential of the specimen S in a similar manner to the electron microscope 100.

In the electron microscope 200, the correction power supply 80 applies a voltage to the correction electrode 50 based on the voltage applied by the specimen power supply 90 to the specimen S. Therefore, with the electron microscope 200, similar operational effects to those of the electron microscope 100 can be achieved.

The invention is not limited to the above-described embodiments, and various modifications can be made. For example, the invention includes configurations that are substantially the same as the configurations described in the embodiments. Substantially same configurations mean configurations having the same functions and methods and results, for example. The invention also includes configurations obtained by replacing non-essential elements of the configurations described in the embodiments with other elements. The invention further includes configurations obtained by adding known art to the configurations described in the embodiments.

## Claims

1. An electron microscope comprising:
an electron source that emits an electron beam;
an electrostatic/electromagnetic field superposed objective lens in which an acceleration tube is built into a magnetic field lens;
a correction electrode placed between the acceleration tube and a specimen; and
a specimen stage that tiltably supports the specimen, wherein
a positive voltage is applied to the acceleration tube,
a negative voltage is applied to the correction electrode, and
a potential on an optical axis between the correction electrode and the specimen is equal to or higher than a potential of the specimen.

2. The electron microscope according to claim 1, wherein
a length of the correction electrode along the optical axis is smaller than an inner diameter of the correction electrode.

3. The electron microscope according to claim 1 or 2, further comprising:
a correction power supply that applies a negative voltage to the correction electrode; and
a specimen power supply that applies a negative voltage to the specimen, wherein
the correction power supply applies a voltage to the correction electrode based on a voltage applied by the specimen power supply to the specimen.

4. The electron microscope according to any one of claims 1 to 3, wherein
the electrostatic/electromagnetic field superposed objective lens includes:
a coil that generates a magnetic field; and
an upper pole and a lower pole that are made of a magnetic material, and
the correction electrode is made of a magnetic material, and connected to the lower pole via an insulating portion.

5. The electron microscope according to any one of claims 1 to 4, further comprising
a detector that detects secondary electrons emitted from the specimen and drawn into the electrostatic/electromagnetic field superposed objective lens.

6. A specimen observation method using an electron microscope that includes:
a specimen stage that tiltably supports a specimen;
an electron source that emits an electron beam;
an electrostatic/electromagnetic field superposed objective lens in which an acceleration tube is built into a magnetic field lens; and
a correction electrode placed between the acceleration tube and the specimen,
the specimen observation method comprising:
operating an optical system including the electrostatic/electromagnetic field superposed objective lens and the correction electrode;
tilting the specimen; and
illuminating the specimen with an electron beam to acquire an electron microscope image, wherein
in the step of operating the optical system,
by applying a positive voltage to the acceleration tube and applying a negative voltage to the correction electrode, an electron beam is accelerated by the acceleration tube and decelerated by a decelerating electric field formed between the acceleration tube and the specimen, and
a potential on an optical axis between the correction electrode and the specimen is set equal to or higher than a potential of the specimen.

7. The specimen observation method according to claim 6, further comprising
changing a tilt angle of the specimen, wherein
a voltage applied to the correction electrode is kept constant even when the tilt angle of the specimen is changed.
